# EUROPÄISCHE PATENTSCHRIFT

(11) **EP 0 802 707 B1**
(45) Veröffentlichungstag und Bekanntmachung des Hinweises auf die Patenterteilung: **24.03.1999**
(21) Anmeldenummer: 97102557.2
(22) Anmeldetag: 18.02.1997
(51) Int. Cl.: H05K 3/32

(54) **Verfahren zum lötfreien Befestigen von Bauelementen auf Leiterbahnen und ein nach dem Verfahren hergestelltes elektrisches Bauteil**
Solderless method for fixing electrical components on a circuit board and electrical assembly according to this method
Procédé de fixation sans soudure de composants électriques sur des pistes conductrices et assemblage électrique obtenu selon ce procédé

(30) Priorität: 16.04.1996 DE 19614879
(43) Veröffentlichungstag der Anmeldung: 22.10.1997
(73) Patentinhaber: Preh-Werke GmbH & Co. KG, 97616 Bad Neustadt (DE)
(72) Erfinder: Bauer, Karl-Heinz, 97616 Bad Neustadt (DE); Brüggemann, Ulrich, 97618 Heustreu (DE); Voll, Walter, 97657 Sandberg (DE)
(74) Vertreter: Pfeiffer, Helmut, Dipl.-Ing.

(56) Entgegenhaltungen:
- EP-A- 0 716 563
- US-A- 3 693 052
- US-A- 4 048 716
- US-A- 4 086 426
- US-A- 4 218 817
- US-A- 4 995 156

## Beschreibung

Die Erfindung betrifft ein Verfahren nach dem Oberbegriff des Patentanspruchs 1 sowie ein nach dem Verfahren hergestelltes elektrisches Bauteil nach dem Oberbegriff des Patentanspruchs 5.

Metallische Leiterbahnen finden sich häufig bei elektrischen Bauteilen, z. B. Schaltern, die aus einem Leitungsnetz mit gestanzten Leiterbahnen bestehen, die mit einem Kunststoffgehäuse verspritzt sind und an denen weitere elektrische Bauelemente angeordnet sind, die mit den Leiterbahnen mechanisch und elektrisch leitend verbunden sind. Bekannt sind solche Leitungsnetze aus der DE-PS 41 15 883.

Aus der EP 0 716 563 A2 ist ein gattungsgemäßes Verfahren zur Kontaktierung des Anschlußdrahtes eines elektrischen Bauelements und eine nach diesem Verfahren hergestellte Anordnung bekannt. Dabei wird die Platine im Bereich neben dem bzw. rund um das Kontaktloch eingekerbt und zu dem Loch bzw. zu dem Anschlußdraht hin verformt. Die Anschlußdrähte sind senkrecht zur Platinenebene durch das jeweilige Loch geführt und werden beim Einkerben der Platine deformiert. Die Einkerbung erfolgt durch zwei koaxial gegeneinander wirkende Kerbstempel. Ein Nachteil ist die gleichzeitige Deformation der Anschlußdrähte, die dadurch in ihren Querschnitten dünner werden und somit an dieser Stelle von der Platine abreißen können.

Der Erfindung liegt die Aufgabe zugrunde, ein Verfahren und ein nach diesem Verfahren hergestelltes elektrisches Bauteil anzugeben, bei der eine sichere mechanische und damit elektrische Verbindung zwischen Bauelement und Leiterbahnen mit geringsten fertigungstechnischem Aufwand erreicht wird.

Gelöst wird die Aufgabe durch die in den Patentansprüchen 1 und 5 enthaltenen kennzeichnenden Merkmale.

Durch die Erfindung wird eine feste und elektrische Verbindung zwischen Leitungsnetzen und Bauelementen erreicht. Auch wird ein Abfall bzw. Abbrechen von Bauelementen von den Leitungsnetzen vermieden, da das Material beidseitig der Anschlußdrähte der Bauelemente und somit über den gebogenen bzw. gekröpften Anschlußdrähten gequetscht wird, ohne daß eine Querschnittsverminderung der Anschlußdrähte erfolgt.

Vorteilhafte Ausführungen sind in den Unteransprüchen enthalten.

Anhand von in Zeichnungen dargestellten Ausführungsbeispielen werden das Verfahren, das Werkzeug und das elektrische Bauteil mit Leitungsnetz nachfolgend näher erläutert.

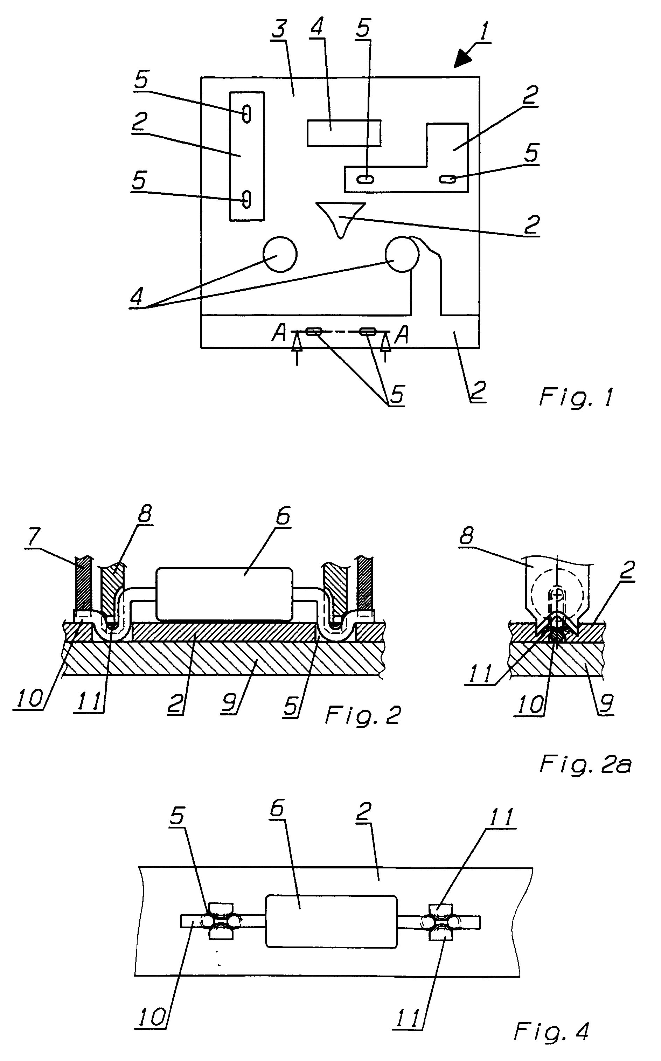

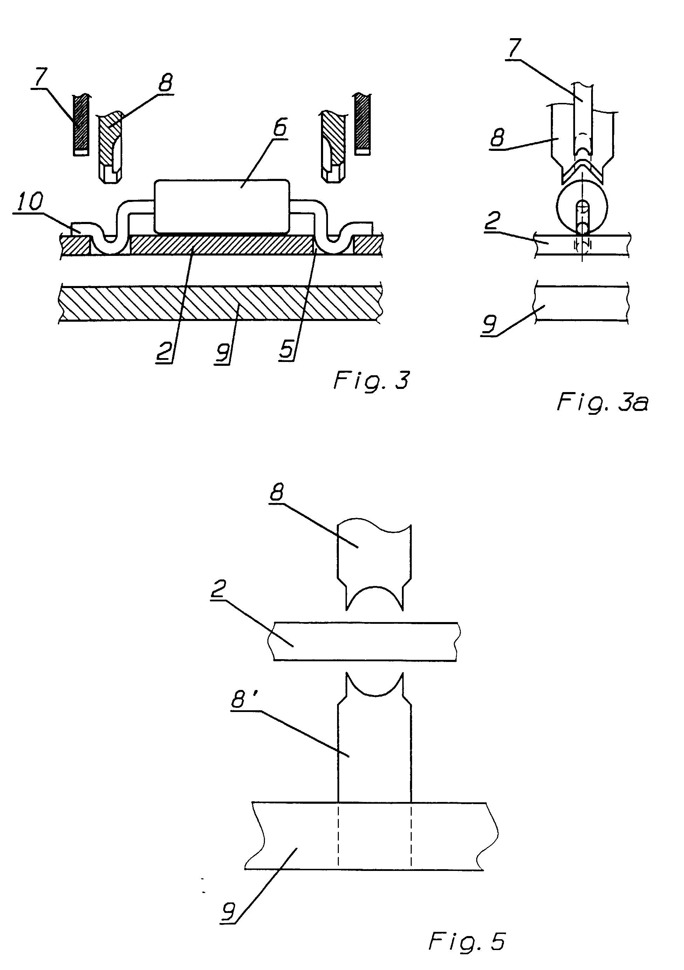

Es zeigen:
Fig. 1
   eine Prinzipdarstellung eines elektrischen Bauteils mit einem Leitungsnetz,
Fig. 2
   eine Kontaktierung eines Bauelementes im Schnitt A-A aus Fig. 1, leicht vergrößert,
Fig. 2a
   die Kontaktierung aus Fig. 2 quer geschnitten,
Fig. 3
   eine Prinzipdarstellung eines Werkzeuges zur Durchführung des erfindungsgemäßen Verfahrens,
Fig. 3 a
   die Darstellung der Stempelwirkung aus Fig. 3, gedreht,
Fig. 4
   eine Quetschung,
Fig. 5, 6
   weitere Ausführungsformen des Werkzeuges.

In Fig. 1 dargestellt ist ein erfindungsgemäßes elektrisches Bauteil mit einem Leitungsnetz 1, bestehend aus vorzugsweise aus Elektrolytkupfer bestehende elektrische Leiterbahnen 2 und einem plastartigen Kunststoff 3, der in herkömmlicherweise um die Leiterbahn 2 gespritzt ist. Es befinden sich in dem Leitungsnetz 1 neben allgemeinen mechanischen Durchführungen 4 weitere Durchführungen 5 zur Aufnahme von Bauelementen 6 mit ihren Anschlußdrähten 10 zur elektrischen Kontaktierung. Neben der elektrischen Kontaktierung erfolgt in den Durchführungen 5 gleichzeitig die mechanische Fixierung der Bauelelemente 6 auf den Leiterbahnen 2. Die Durchführungen 5 sind dabei vorzugsweise langlochförmig ausgeführt.

Das Kontaktierverfahren läuft dabei wie folgt ab.

In einer nicht näher dargestellten Fertigungsstraße werden die Anschlußdrähte 10 der Bauelemente 6 vorgebogen und über ein Programm in die einzelnen Durchführungen 5 eingesetzt. Die Biegung bzw. Kröpfung der Anschlußdrähte 10 ist vorzugsweise so zu gestalten, daß sie aus dem unteren Teil der Durchführung 5 nicht hinausragen. Die Anschlußenden der gebogenen bzw. gekröpften Anschlußdrähte 10 verlaufen dabei parallel zur Ebene der Leiterbahn 2, wie in Fig. 2 dargestellt. Danach werden, wie in Figur 2 bis 3a angedeutet, über eine Halterung 7 der Fertigungsstraße die Anschlußdrähte 10 des Bauelementes 6 niedergehalten. Die Halterung 7 befindet sich dabei nahe der Durchführung 5. Nachdem der Niederhalter 7 seine Position eingenommen hat, wobei gleichzeitig ein Gegenhalter 9 von unten gegen das Leiterbahnmaterial 2 zu dessen mechanischer Fixierung geführt wird, wird ein Stempel 8 einer nicht näher dargestellten Stempelpresse auf die Leiterbahn 2 mit vorbestimmtem Eindrückweg in unmittelbarer Nähe der Durchführung 5, wie in Fig. 2a dargestellt, gebracht. Dabei weist der Stempel 8 vorzugsweise eine Aufnahme für den Niederhalter 7 auf. Bedingt durch eine Kraft, die über den Stempel 8 auf das Leiterbahnmaterial 2 wirkt, findet eine Materialquetschung bzw. Materialverdrängung 11 statt.

Dieses verdrängte Leiterbahnmaterial 2 wird in die Durchführung 5 gedrückt und das entlang der Anschlußdrähte 10 befindliche Leiterbahnmaterial 2 der außenliegenden Seiten- bzw. Öffnungswandungen gegen die innenliegenden Seiten- bzw. Öffnungswandungen der Durchführung 5 gequetscht, so daß das Leiterbahnmaterial 2 die Anschlußdrähte 10 der Bauelemente 6 seitlich fest umschließt und elektrisch kontaktiert. Eine solche Quetschung zeigt Figur 4. Die Materialverdrängung 11 erfolgt gleichzeitig und beidseitig der Durchführungen 5 in dem Leiterbahnmaterial 2.

Die Form des Stempels 8, wie skizzenhaft in den Figuren 3 und 3a dargestellt ist, bestimmt die Menge des verdrängten Materials der Leiterbahn 2. Ein zu spitzer Stempel 8 würde eher eine Zerstörung des Leiterbahnmaterials 2 bewirken als eine Verdrängung desselbigen. Der Stempel 8 teilt sich in einen oberen und einen unteren Teil. Am unteren Teil befinden sich zwei gegenüberliegende keilförmige und dabei einen inneren Winkel bildende Spitzen (Schneiden). Der äußere Bereich des unteren Teils ist zum oberen Stempelteil verjüngt, um die Materialverdrängung 11 zu realisieren. Je nach Dicke der Anschlußdrähte 10 der Bauelemente 6 und der Breite der Durchführungen 5 gestaltet sich der Stempel 8 in seinen seitlichen Abmaßen und seinem Winkel unterschiedlich, so daß die Materialverdrängungen 11 bei kleineren Bauelementen 6, wie beispielsweise Leuchtdioden, in ihren Abmaßen kleiner sind als bei größeren Bauelementen 6, beispielsweise Widerständen. Die Dicke der Anschlußdrähte 10 der Bauelemente 6 beeinflußt auch die Biegeradien der Anschlußdrähte 10.

So benötigen dicke Anschlußdrähte 10 größere, vorteilhafterweise langlochförmige Durchführungen 5 als dünnere Anschlußdrähte 10, für die eine kreisrunde Durchführung 5 ausreicht. Die Dicke der Anschlußdrähte 10 hat auch Einfluß auf die Form des Stempels 8. So ist der innere Winkel der beiden keilförmigen zueinander stehenden Schneiden für die Quetschung von Diodenanschlüssen kleiner als für die Quetschung der Widerstandsanschlüsse, d. h. der innere Winkel des Stempels 8 besitzt vorzugsweise 106° bis 120°.

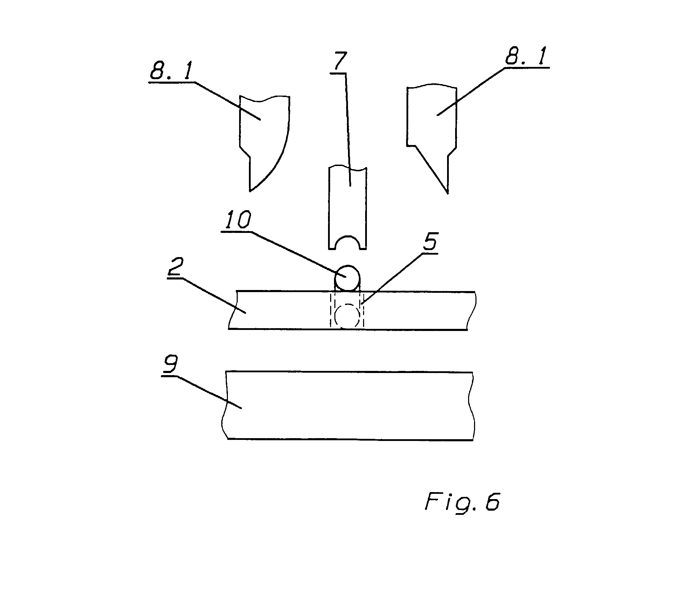

Es ergibt sich von selbst, daß Änderungen im Rahmen der Patentansprüche möglich sind. So kann das Leitungsnetz 1 nur aus den Leiterbahnen 2 ohne Umspritzung mit Kunststoff 3 bestehen. Auch kann der Stempel 8 auf einen Keil 8.1 reduziert werden, wenn die einseitige Materialverdrängung 11 zum Festhalten des Anschlußdrahtes 10 in der Durchführung 5 ausreichend ist. Hierbei erfolgt nur eine Materialverdrängung 11, wobei eine der parallelen Langloch- bzw. Öffnungswandung der Durchführung 5 in Richtung der anderen Langlochwandung gepreßt wird. Eine Doppelanordnung des Keiles 8.1 (Fig. 6) ist ebenfalls möglich, so daß ähnlich wie mit dem Stempel 8 eine beidseitige Materialverdrängung 11 in dem Leiterbahnmaterial 2 möglich ist.

Desweiteren besteht die Möglichkeit, die Gegenhalter 9 in bekannter Art mit einem dem oberen Stempel 8 entgegenwirkenden Stempel 8' zu bestücken (Fig. 5).

Wie bereits zu Fig. 1 ausgeführt, besteht das erfindungsgemäße Bauteil aus einem Leitungsnetz 1, das aus gestanzten Leiterbahnen 2 besteht, die elektrisch getrennt und mechanisch gehalten sind, beispielsweise sind sie durch einen Kunststoff 3 umspritzt. Zwischen den einzelnen Leiterbahnen 2 sind weitere elektrische Bauelemente 6 angeordnet, die mit den Leiterbahnen 2 in elektrischem Kontakt stehen. Erfindungsgemäß weisen hierfür die Leiterbahnen 2 die erwähnten Durchführungen 5 auf, in die die entsprechend den Durchführungsabständen und -größen gebogenen Anschlußdrähte 10 hineingesteckt sind.

Mittels des erwähnten Verfahrens und ggf. unter Benutzung des angegebenen Werkzeuges sind die Durchführungen 5 zur Aufnahme der Anschlußdrähte 10 nach dem Einlegen der Anschlußdrähte 10 zur elektrischen Kontaktierung zerquetscht, d. h. die Durchführungswände wurden dabei in die Durchführungen 5 hineingequetscht. Die dabei auftretende Materialverdrängung belastet die Anschlußdrähte 10, so daß ein dauerhafter elektrischer Kontakt zwischen den Leiterbahnen 2 und den Anschlußdrähten 10 besteht.

Vorteilhafterweise ist vorgesehen, daß die Leiterbahndurchführungen 5 einen den Anschlußleitungen 10 angepaßten Querschnitt aufweisen, langlochförmig ausgebildet sind und die Anschlußleitungen 10 eine Kröpfung aufweisen, die in die Durchführungen 5 hineinragt, wobei die Anschlußleitungen 10 durch die Materialverdrängung 11 neben den Durchführungen 5 gegen die Wandungen der Durchführungen 5 gepreßt sind oder durch eine Materialverdrängung 11 neben einer oder beider der parallelen Langlochwandungen der Durchführungen 5 gegen die andere Langlochwandung, wie in Fig. 2 und Fig. 4 dargestellt ist.

## Patentansprüche

1. Verfahren zum lötfreien Befestigen von Bauelementen auf Leiterbahnen, wobei Anschlußdrähte des Bauelements in Durchführungen fixiert werden und mindestens auf einer Seite der Leiterbahnen mindestens ein Segment des Durchführungsrandes durch einen Stempel zu dem Anschlußdraht hin verformt wird, **dadurch gekennzeichnet**, daß Biegungen oder Kröpfungen der Anschlußdrähte (10) in die Durchführungen (5) eingeführt werden, wobei sich die Anschlußenden auf der dem Bauelement (6) zugewandten Seite der Leiterbahnen (2) befinden, und das Leiterbahnmaterial (2) neben den Durchführungen (5) in die Durchführungen (5) gequetscht wird, so daß die Anschlußdrähte seitlich belastet und electrisch Kontaktiert sind.

2. Verfahren nach Anspruch 1, **dadurch gekennzeichnet**, daß die Anschlußdrähte (10) der Bauelemente (6) den Durchführungen (5) angepaßt vorgebogen werden.

3. Verfahren nach den Anspruch 2, **dadurch gekennzeichnet**, daß das Bauelement (6) mit seinen Anschlußdrähten (10) in Durchführungen (5) von Leiterbahnen (2) des Leitungsnetzes ( 1 ) eingesetzt, mit Hilfe eines Niederhalters (7) auf die Leiterbahnen (2) gedrückt und durch einen Stempel (8) das Leiterbahnmaterial (2) in die Durchführungen (5) gequetscht wird.

4. Verfahren nach einem der Ansprüche 1 bis 3, **dadurch gekennzeichnet,** daß der Stempel (8) mit vorbestimmtem Eindrückweg in die Oberfläche der Leiterbahnen (2) neben den Durchführungen (5) hineingedrückt wird, wobei eine Materialverdrängung ( 11 ) in die Durchführungen (5) erfolgt.

5. Elektrisches Bauteil, hergestellt nach dem Verfahren gemäß Anspruch 1, wobei Leiterbahnen Durchführungen zur Aufnahme von Anschlußdrähten elektrischer Bauelemente aufweisen, in denen die Anschlußdrähte durch eine Quetschverbindung des Leiterbahnmaterials seitlich belastet und elektrisch Kontaktiert sind, **dadurch gekennzeichnet**, daß die Anschlußdrähte (10) eine Biegung oder Kröpfung aufweisen, die in die Durchführungen (5) hineinragt, wobei sich die Anschlußenden parallel zu der den Bauelementen (6) zugewandten Seite der Leiterbahnen (2) befinden.

6. Elektrisches Bauteil nach Anspruch 5, **dadurch gekennzeichnet**, daß die Durchführungen (5) langlochförmig ausgebildet sind und eine Materialverdrängung (11) an einer oder an beiden der parallel Langlochwandungen der Durchführungen (5) gegen die andere Langlochwandung aufweisen.

## Claims

1. Method for solderless securement of components on printed conductors, wherein terminal wires of the component are fixed in bushings and at least on one side of the printed conductors at least one segment of the bushing edge is deformed towards the terminal wire by means of a stamp, characterised in that bent or offset portions of the terminal wires (10) are introduced into the bushings (5), with the terminal ends being located on the side of the printed conductors (2) that faces the component (6), and the printed-conductor material (2) next to the bushings (5) is squeezed into the bushings (5) so that the terminal wires are loaded laterally and are contacted electrically.

2. Method according to claim 1, characterised in that the terminal wires (10) of the components (6) are pre-bent so as to be adapted to the bushings (5).

3. Method according to claim 2, characterised in that the terminal wires (10) of the component (6) are inserted into bushings (5) of printed conductors (2) of the conductor system (1), the component (6) is pressed unto the printed conductors (2) with the aid of a holding-down device (7), and the printed-conductor material (2) is squeezed into the bushings (5) by means of a stamp (8).

4. Method according to one of claims 1 to 3,
characterised in that the stamp (8) is pressed into the surface of the printed conductors (2) next to the bushings (5), pressing in by a predetermined amount, in which case a displacement of material (11) into the bushings (5) takes place.

5. Electrical component produced according to the method in accordance with claim 1, wherein printed conductors have bushings to receive terminal wires of electrical components in which the terminal wires are loaded laterally by a crimp connection of the printed-conductor material and are contacted electrically, characterised in that the terminal wires (10) have a bent or an offset portion which projects into the bushings (5), with the terminal ends being located parallel to the side of the printed conductors (2) that faces the components (6).

6. Electrical component according to claim 5,
characterised in that the bushings (5) are formed as an elongated hole and experience a displacement of material (11) on one or on both of the parallel elongated-hole walls of the bushings (5) towards the other elongated-hole wall.

## Revendications

1. Procédé de fixation sans soudure de composants électriques sur des pistes conductrices, dans lequel des fils conducteurs de raccordement du composant sont fixés dans des traversées et, au moins d'un côté des pistes conductrices, au moins un segment de la bordure de la piste conductrice est déformée par un poinçon en direction du fil conducteur de raccordement, caractérisé par le fait que l'on introduit dans les traversées (5) des cintrages ou des ondulations des fils conducteurs de raccordement (10), procédé dans lequel les extrémités de raccordement se trouvent du côté des pistes conductrices (2) orientées vers le composant (6) et le matériau (2) de la piste de raccordement situé près des traversées (5) est refoulé dans les traversées (5) de sorte que les fils conducteurs de raccordement sont contraints latéralement et sont mis en contact électrique.

2. Procédé selon la revendication 1, caractérisé par le fait que les fils conducteurs de raccordement (10) des composants (6) sont précintrés en accord avec les traversées (5).

3. Procédé selon la revendication 2, caractérisé par le fait que, par ces fils conducteurs de raccordement (10), on insère le composant (6) dans des traversées (5) de pistes conductrices (2) du réseau (1), qu'on l'appuie sur des pistes conductrices (2) à l'aide d un presse-fil (7), et qu'au moyen d'un poinçon (8) on refoule le matériau (2) de la piste conductrice dans les traversées (5).

4. Procédé selon l'une des revendications 1 à 3, caractérisé par le fait que le poinçon (8) s'enfonce, avec une course d'enfoncement prédéterminée, dans la surface des pistes conductrices (2) à côté des traversées (5), ce dont résulte un refoulement (11) du matériau dans les traversées (5).

5. Assemblage électrique réalisé selon le procédé de la revendication 1, dans lequel des pistes conductrices présentent des traversées pour recevoir des fils conducteurs de raccordement de composant électrique dans lesquels les fils conducteurs de raccordement sont contraints latéralement et mis en contact électrique par une liaison, par refoulement, avec le matériau de la piste conductrice, caractérisé par le fait que les fils conducteurs de raccordement (10) présentent un cintrage ou une ondulation qui pénètre dans les traversées (5), les extrémités de raccordement se trouvant parallèles à la face des pistes conductrices (2) orientée vers les composants (6)

6. Composant électrique selon la revendication 5, caractérisé par le fait que les traversées (5) ont la forme de lumière et, sur l'une, ou sur les deux, des parois parallèles de la lumière des traversées (5), présentent un refoulement (11) du matériau en direction de l'autre paroi de la lumière.
